Europäisches Patentamt

European Patent Office

Office européen des brevets

(19)

(11) Veröffentlichungsnummer : **0 085 837**
**B1**

(12) **EUROPÄISCHE PATENTSCHRIFT**

(45) Veröffentlichungstag der Patentschrift :
16.06.87

(21) Anmeldenummer : 83100213.4

(22) Anmeldetag : 12.01.83

(51) Int. Cl.⁴ : **H 05 K 13/02**, B 65 G 49/00,
B 23 Q 39/00

(54) **Fertigungseinrichtung zur Bearbeitung von Kleinbauteilen, insbesondere von elektrischen Bauelementen.**

(30) Priorität : 15.01.82 DE 3201086

(43) Veröffentlichungstag der Anmeldung :
17.08.83 Patentblatt 83/33

(45) Bekanntmachung des Hinweises auf die Patenterteilung : 16.06.87 Patentblatt 87/25

(84) Benannte Vertragsstaaten :
CH DE FR GB LI

(56) Entgegenhaltungen :
DE-A- 1 456 602
DE-B- 1 556 027
DE-B- 2 249 553
US-A- 2 890 456
US-A- 3 286 740
US-A- 4 288 023
TECHNICAL DIGEST WESTERN ELECTRIC, Band 50,
April 1978, New York, R.L. MOORE "Rectilinear feed
drive for advancing electronic device packages",
Seiten 19, 20

(73) Patentinhaber : Siemens Aktiengesellschaft Berlin
und München
Wittelsbacherplatz 2
D-8000 München 2 (DE)

(72) Erfinder : Stadler, Heinz
Mettnauer Strasse 19
D-8000 München 60 (DE)
Erfinder : Heinzl, Alfred, Dipl.-Ing.
Geigenbergerstrasse 29
D-8000 München 71 (DE)

EP 0 085 837 B1

**Beschreibung**

Die Erfindung bezieht sich auf eine Fertigungseinrichtung zur Bearbeitung von Kleinbauteilen, insbesondere von elektrischen Bauelementen, gemäß dem Oberbegriff des Patentanspruchs 1.

Bei der Fertigung technischer Produkte, etwa von elektrischen Bauelementen, ist meist eine Vielzahl von Arbeitsschritten erforderlich, die jeweils mit speziellen Werkzeugen durchgeführt werden. So müssen beispielsweise bei der Herstellung eines elektromagnetischen Relais Blechteile gestanzt, gebogen, vernietet, verschweißt, in einen Träger eingesteckt oder sonstwie bearbeitet werden. Alle diese Arbeitsschritte werden vielfach noch in herkömmlicher Arbeitsweise jeweils an Handarbeitsplätzen durchgeführt, wobei das Spezialwerkzeug auf dem Werkzeugtisch angeordnet ist und die zu bearbeitenden Bauelemente oder sonstigen Kleinteile von Hand in das Werkzeug eingeführt werden. Dies gilt auch dann noch, wenn an diesem Werkzeug Zusatzteile, wie Schrauben, Niete oder Blechteile automatisch mit zugeführt werden. Nach dem Bearbeitungsschritt müssen die bearbeiteten Bauelemente wieder von Hand in Transportbehälter gelegt und zum nächsten Werkzeug transportiert werden. Eine derartige Fertigung ist sehr personalintensiv, und das gilt auch dann noch, wenn an dem einzelnen Werkzeug nicht mehr jedes Bauelement einzeln eingelegt wird, sondern jeweils eine Gruppe von Bauelementen auf einem Magazin angeordnet ist.

Daneben sind aber auch bereits vollautomatisierte Fertigungsstraßen bekannt, bei denen eine Vielzahl von Werkzeugen in fester Reihenfolge einander zugeordnet ist und das zu bearbeitende Produkt automatisch von einem Werkzeug zum anderen bewegt wird. Diese Fertigungsstraßen sind allerdings sehr aufwendig, erfordern eine umfangreiche Vorplanung und einen hohen Entwicklungsaufwand, so daß sie nur dann wirtschaftlich sind, wenn eine hohe Auslastungsquote sichergestellt ist. Da diese Fertigungsstraßen ganz speziell für ein bestimmtes Produkt ausgelegt sind, sind sie nur schwer an Produktänderungen anzupassen. Insbesondere sind diese Fertigungsstraßen aufgrund der vielen kettenförmig aneinander gereihten Werkzeuge sehr störanfällig und gleichzeitig auch aufwendig in der Bedienung und Wartung.

Eine Fertigungseinrichtung der eingangs genannten Art ist grundsätzlich aus der DE-A-1 456-602 bekannt. Dabei sei darauf hingewiesen, daß unter dem Begriff eines « Magazins », wie er im Oberbegriff des Patentanspruchs 1 verwendet ist, im folgenden jede Art von Vorratsbehälter für gleiche oder gleichartige Gegenstände verstanden werden soll, selbst wenn diese Magazine nicht unabhängig voneinander handhabbar sind. In diesem Sinne sind bei der Einrichtung gemäß DE-A-1 456 602 Transporteinheiten in Form von stapelbaren Platten vorgesehen, wobei in jeder dieser Platten parallel ausgerichtete Magazine in Form von als Nuten ausgebildeten, längs verlaufenden Spuren eingeformt sind. Die Werkstücke, beispielsweise elektronische Bauelemente, sind in diesen Nuten in jeweils einer Reihe angeordnet. Die als Transporteinheiten dienenden Platten werden im Eingabeteil aufeinandergestapelt. Um die einzelnen Bauteile dem Bearbeitungswerkzeug zuzuführen, wird jeweils eine Transporteinheit von der Unterseite des Stapels entnommen, wobei zusätzliche Abstützungen für den restlichen Stapel erforderlich sind, und diese Transporteinheit wird schrittweise horizontal verschoben, damit nacheinander aus den nutenförmigen Magazinen die Kleinbauteile herausgeschoben und auf das Transportband gebracht werden können. In ähnlicher Weise erfolgt dann das Einführen der bearbeiteten Bauteile in die im Ausgabeteil angeordnete Transporteinheit.

Obwohl eine solche bekannte Transporteinheit also die Bauteile lediglich in einer zweidimensionalen Anordnung aufnimmt, muß sie verhältnismäßig kompliziert gestaltet sein ; beispielsweise müssen die nutenförmigen Magazine an die Konturen der zu bearbeitenden Bauteile angepaßt sein. Für andere Bauteiltypen muß also die gesamte Transporteinheit neu hergestellt werden. Weiterhin ist die Vereinzelung der Bauteile, die zur Einzelbearbeitung an dem Werkzeug vorbeigeführt werden, verhältnismäßig kompliziert, da jedes Bauteil einzeln auf das Transportband geschoben wird. Das bedeutet aber, daß die einzelnen Bauelemente sich auf dem Transportband leicht verschieben können und somit sich bei ihrer Ankunft am Bearbeitungswerkzeug unter Umständen nicht in einer genau definierten Position befinden. Für Bauelemente mit einer komplizierten Form müßte ohnehin die Vorschubeinrichtung ein ganz speziell gestaltetes Transportband aufweisen, um die Bauteile in geeigneter Weise abstützen zu können.

Aus der DE-B-2 249 553 ist weiterhin eine Einrichtung zum aufeinanderfolgenden Bewegen von länglichen Stückgütern aus mindestens teilweise ferromagnetischem Material bekannt, wobei es sich bei diesen Stückgütern beispielsweise um Probenbehälterträger handelt. Diese Probenbehälterträger werden in einer Eingangsstation aufeinandergestapelt, von dort einzeln entnommen und über eine Bearbeitungsstation zu einer Ausgangsstation transportiert, wo sie wiederum in einen Stapel eingefügt, von dem Stapel aber wiederum einzeln entnommen werden. Für die Bearbeitung und für den Transport einer großen Zahl von Kleinbauteilen ist diese Anordnung mit den lediglich in einem Schacht übereinandergestapelten Magazinen nicht geeignet. Vor allem ist aus dieser Druckschrift keine Möglichkeit zu entnehmen, Kleinbauteile auf einfache Weise in einer Transporteinrichtung mit großem Fassungsvermögen zusammenzuführen.

Aus der DE-B-1 556 027 ist schließlich eine automatische Fördereinrichtung für Stapelplatten bekannt, bei der in den einzelnen Platten Bauelemente in zweidimensionaler Anordnung in Einzelaufnahmen enthalten sind. Diese Platten werden dort jeweils selbst durch eine Bearbeitungsstation hindurchgeführt, wobei bei jedem Bearbeitungsschritt jeweils eine ganze Reihe von Bauelementen mit einem Dichtungsmittel gefüllt wird. Für eine Fertigungseinrichtung, bei der schon aus Gründen der Werkzeugauslegung eine Einzelbearbeitung jedes Bauteils erforderlich ist, kann eine solche Transporteinheit nicht verwendet werden.

Aufgabe der Erfindung ist es, eine Fertigungseinrichtung gemäß dem Oberbegriff des Patentanspruchs 1 zu schaffen, die die oben beschriebenen Vorteile eines Einzelarbeitsplatzes aufweist und die eine verbesserte Transporteinrichtung besitzt, wobei die Bauteile einfacher und gefahrloser in einer Transporteinrichtung großer Kapazität von der einen Fertigungseinrichtung zur anderen transportiert werden können, und wobei gleichzeitig die Vereinzelung im Eingabeteil der Fertigungseinrichtung sowie die Zusammenführung in die Transporteinheit im Ausgabeteil vereinfacht sind.

Erfindungsgemäß wird diese Aufgabe mit den kennzeichnenden Merkmalen des Patentanspruchs 1 gelöst.

Die erfindungsgemäße Fertigungsvorrichtung kann mit einem oder mehreren Werkzeugen bestückt werden und einen oder einige aufeinanderfolgende Fertigungsschritte unabhängig durchführen, ohne daß eine ständige manuelle Zuführung von Einzelteilen oder von einzelnen Magazinen erforderlich ist. Dies ergibt sich aus dem großen Fassungsvermögen der verwendeten Kassetten, welche in mehreren Etagen jeweils mehrere Magazine aufnehmen können. Wenn der ganze Inhalt einer Kassette abgearbeitet ist, kann die im Ausgabeteil nunmehr gefüllte Kassette zur nächsten Fertigungseinrichtung transportiert werden, während in den Eingabeteil eine neue gefüllte Kassette zur Verarbeitung eingesetzt wird. Dieser Transport der Kassetten bringt gegenüber dem manuellen Einlegen von Einzelteilen eine erhebliche Vereinfachung. Aus der Erfindung ergibt sich also eine Modulbauweise der einzelnen hintereinander benötigten Fertigungseinrichtungen, wobei sich eine geringe Störanfälligkeit und eine leichte Anpassungsmöglichkeit an Produktänderungen ergibt. Durch Auswechseln des jeweiligen Werkzeugs auf der erfindungsgemäßen Fertigungseinrichtung kann diese immer wieder für neue Produkte verwendet werden.

Die Hebevorrichtung im Eingabeteil bzw. im Ausgabeteil kann zweckmäßigerweise über Hubzylinder verstellbar sein, welcher beispielsweise über ein Klinkenschaltwerk wirkt. Zus Ausschieben bzw. Einschieben der Magazine können zweckmäßig gestaltete, beispielsweise gabelförmige Schieber verwendet werden, welche ihrerseits über Druckluftzylinder betätigbar sind. Die Vorschubeinrichtung enthält in einer zweckmäßigen Ausführungsform eine Vorschubstange, welche durch einen entsprechenden Antrieb eine sinusförmige Bewegung ausführt und dadurch die auf einer Führungschiene liegenden Magazine an dem Werkzeug vorbeiführt.

Die bei der erfindungsgemäßen Vorrichtung verwendbaren Kassetten enthalten zweckmäßigerweise an ihrer Oberseite eine asymmetrisch angeordnete Griffmulde, mit deren Hilfe die Kassette von Hand transportiert werden kann. Ein Dekkel an der Vorderseite der Magazine kann das Eindringen von Staub und das Herausfallen von Magazinen beim Transport verhindern. Im übrigen sind die Kassetten zweckmäßigerweise mit Öffnungen in der Rückseite an den Schieber der Ausschiebeeinrichtung angepaßt.

Weitere Einzelheiten der Erfindung sind nachfolgend an einem Ausführungsbeispiel anhand der Zeichnung näher erläutert. Es zeigt

Figur 1   eine perspektivische Gesamtansicht einer erfindungsgemäß aufgebauten Fertigungseinrichtung,

Figur 2   eine Ausschiebeeinrichtung mit einer Kassette,

Figur 3   eine Einschiebevorrichtung,

Figur 4   eine Hebevorrichtung für die Eingabe- bzw. Ausgabeeinheit in schematischer Darstellung,

Figur 5   eine schematische Darstellung einer Vorschubeinrichtung,

Figur 6   einen Schnitt VI-VI aus Fig. 5.

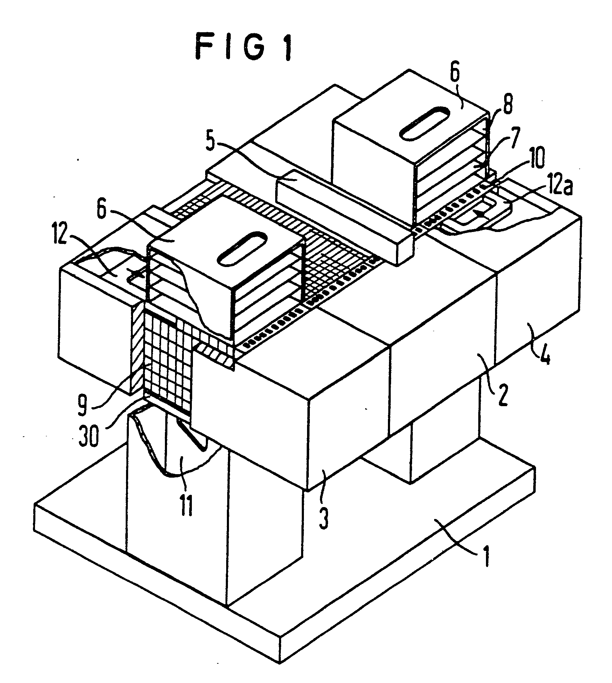

Die Fertigungseinrichtung nach Fig. 1 umfaßt einen Werkzeugtisch 1, der in drei Bereiche, nämlich einen Bearbeitungsteil 2, einen Eingabeteil 3 und einen Ausgabeteil 4 gegliedert ist. Der in der Mitte angeordnete Bearbeitungsteil trägt ein Werkzeug 5, welches beliebig austauschbar ist und nur schematisch angedeutet ist. Im Eingabeteil 3 und im Ausgabeteil 4 ist jeweils eine Kassette 6 einsetzbar angeordnet. Diese Kassetten sind untereinander völlig gleich und austauschbar. Jede Kassette 6 ist durch Zwischenböden 7 in eine Reihe von Etagen 8 unterteilt, wobei in jeder Etage 8 mehrere stabförmige Magazine 9 Platz finden. Jedes Magazin 9 wiederum kann mehrere zu bearbeitende Kleinbauteile 10, beispielsweise Relais oder andere Bauelemente, tragen. Nimmt man beispielsweise an, daß jedes Magazin 9 zehn Bauelemente 10 trägt, in jeder Etage 8 der Kassetten 6 jeweils zehn Magazine Platz finden und die Kassette 6 jeweils zehn Etagen besitzt, so können in der Fertigungseinrichtung also 1 000 Bauelemente verarbeitet werden, bis die Kassetten gewechselt werden müssen.

Die Kassetten 6 sitzen jeweils auf einer Hebeeinrichtung 11, mittels derer jeweils schrittweise eine Etage 8 nach der anderen in die Arbeitshöhe gebracht werden kann. Die im Eingabeteil 3 angeordnete Kassette 6 wird voll bestückt eingesetzt ; sie enthält die zu bearbeitenden Bauelemente. Während des Betriebs der Anlage wird über eine Ausschiebevorrichtung 12 jeweils ein Magazin 9 nach dem anderen aus der gerade in Arbeitshöhe befindlichen Etage 8 auf eine (in Fig. 1 nicht sichtbare) Vorschubeinrichtung geschoben und mit dieser am Werkzeug 5 schrittweise zur Bearbeitung vorbeigeführt. Über eine Einschiebegabel 12a im Ausgabeteil 4 wird entsprechend schrittweise jeweils ein Magazin 9 nach dem anderen in die dort angeordnete Kassette 6 eingeschoben. Sobald alle Magazine aus der Kassette 6 des Einschiebeteils 3 in die Kassette 6 des Ausschiebeteils 4 gewandert sind, wird diese volle Kassette entnommen und durch eine leere ersetzt, während im Eingabeteil 3 wiederum eine volle Kassette 6 eingesetzt wird.

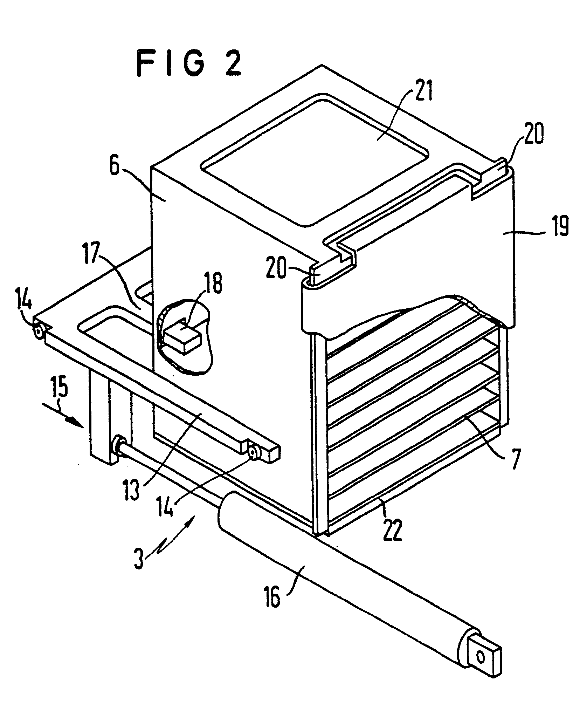

Fig. 2 zeigt die Ausschiebeeinrichtung des Eingabeteils 3 zusammen mit einer Kassette 6 in detaillierterer Darstellung. Die Ausschiebeeinrichtung besitzt im wesentlichen einen Schieber 13, welcher über Rollen 14 auf dem Eingabeteil 3 horizontal beweglich gelagert ist. Der Schieber 13 wird von einem Druckluftzylinder 16 angetrieben, welcher den Schieber schrittweise in Richtung des Pfeiles 15 bewegt. Bei dieser Bewegung werden die Gabelenden 17 (nur eines dargestellt) von der Rückseite her in die Kassette 6 eingeschoben ; sie greifen an dem hintersten Magazin der betreffenden Etage an und schieben dabei das vorderste Magazin (Fig. 1) dieser Etage auf die Vorschubeinrichtung. Die Kassetten 6 besitzen zu diesem Zweck jeweils in der Rückwand der einzelnen Etagen 8 Öffnungen 18 für die Durchführung der Gabelenden 17. Sind alle Magazine aus einer Etage der Kassette ausgeschoben, wird der Schieber 13 über den Druckluftzylinder 16 aus der Kassette nach hinten herausgezogen, so daß die Kassette um eine Etage angehoben werden kann.

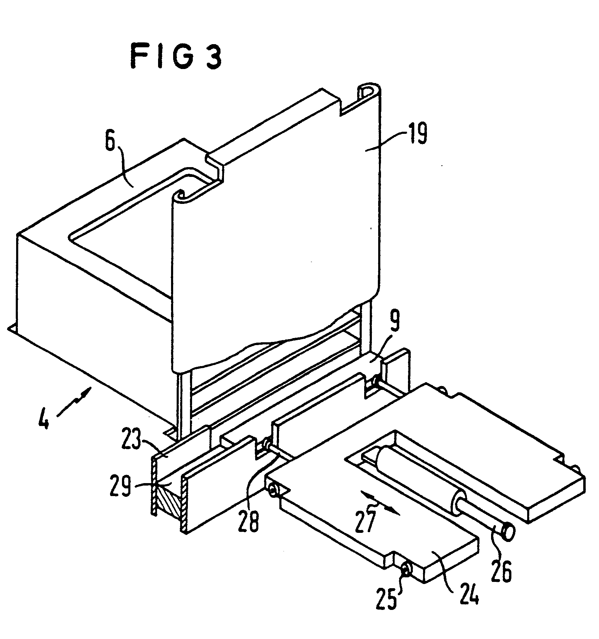

Die Kassette selbst ist weitgehend geschlossen, um die enthaltenen Bauteile möglichst vor Staub zu schützen. In der Rückseite sind lediglich die Öffnungen 18, die jedoch von den Magazinen abgedeckt werden, vorgesehen, während die Vorderseite mit einem Deckel 19 verschließbar ist, welcher beiderseits an Führungsstegen 20 der Kassette gehalten wird. Dadurch kann der Deckel nach oben abgezogn werden. Zweckmäßig ist es jedoch, den Deckel 19 während der Verarbeitung am Magazin zu belassen. Durch einen Anschlag 23 am Eingabeteil bzw. am Ausgabeteil (siehe Fig. 3) kann sichergestellt werden, daß der Deckel mit dem Absenken der Kassette entlang den Führungsstegen nach oben geschoben wird, wobei jeweils nur diejenige Etage 8 nach vorne offen ist, aus der Magazine ausgeschoben oder in die Magazine eingeschoben werden sollen. Der über den Werkzeugtisch hinausstehende Teil der Kassette bleibt also in diesem Fall abgedeckt. An der Oberseite ist die Kassette 6 mit einer asymmetrisch angeordneten Griffmulde 21 versehen, welche einerseits zum Transport der Kassette, andererseits aber auch zur Ablage von Laufkarten oder sonstigen Begleitunterlagen dienen kann. Die Kassetten sind damit auch gut stapelbar. Die durchgehenden Zwischenböden 7 verhindern, daß Bauteile bei Erschütterung oder bei Schräglage der Kassette von den Magazinen fallen können. Schließlich sind an der Unterseite der Kassette 6 jeweils Gleitstücke angeformt, welche das Schieben der Kassette auf Tischen, Transportmitteln und dergleichen erleichtern.

Fig. 3 zeigt eine detailliertere Darstellung der Einschiebevorrichtung, welche im Ausgabeteil 4 der Fertigungseinrichtung angeordnet ist. Die Kassette 6 ist hier abgesenkt dargestellt, so daß lediglich die obersten Etagen 8 sichtbar sind. Während des Absenkens wird der Deckel 19 angehoben, wobei er sich am Anschlag 23 abstützt. Die Einschiebevorrichtung besitzt analog zur Ausschiebevorrichtung einen Schieber 24, welcher über Rollen 25 auf dem Werkzeugtisch gelagert ist und durch einen Hubzylinder 26 in Richtung des Doppelpfeiles 27 bewegbar ist. Über die Einschiebebolzen 28 greift der Schieber 24 jeweils an einem Magazin 9 an, welches von der Vorschubeinrichtung (nur Magazinführung 29 dargestellt) in den Ausgabeteil befördert wurde, und schiebt dieses in die Kassette 6. Auf diese Weise wird Etage für Etage der Kassette gefüllt.

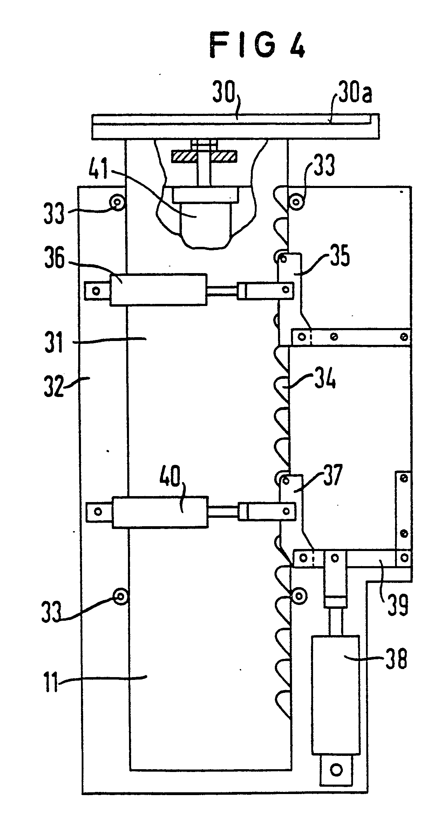

Fig. 4 zeigt eine Hebevorrichtung, wie sie sowohl im Eingabeteil als auch im Ausgabeteil Verwendung finden kann. Diese Hebevorrichtung 11 besitzt an ihrer Oberseite eine Tragplatte 30 mit einer Stellfläche 30a für die jeweils aufgesetzte Kassette. Diese Tragplatte 30 sitzt auf einem Träger 31, welcher in einem Führungsteil 32 über Lagerelemente 33 geführt ist und an einer Seite eine Zahnung 34 aufweist. Über eine Rastklinke 35, welche von einem Klinkenzylinder 36 betätigt wird, wird der Träger 31 jeweils in einer bestimmten Höhe festgehalten, so daß aus einer entsprechend in Arbeitshöhe liegenden Etage der Kassette 6 die Magazine ausgebracht werden können. Über die Transportklinke 37, welche durch den Hubzylinder 38 über den Hebel 39 sowie außerdem über den Klinkenzylinder 40 betätigbar ist, kann der Träger 31 schrittweise angehoben werden. Um beim Absenken der Kassette starke Stoßerschütterungen zu vermeiden, ist im Träger 31 außerdem ein Dämpfungszylinder 41 angeordnet.

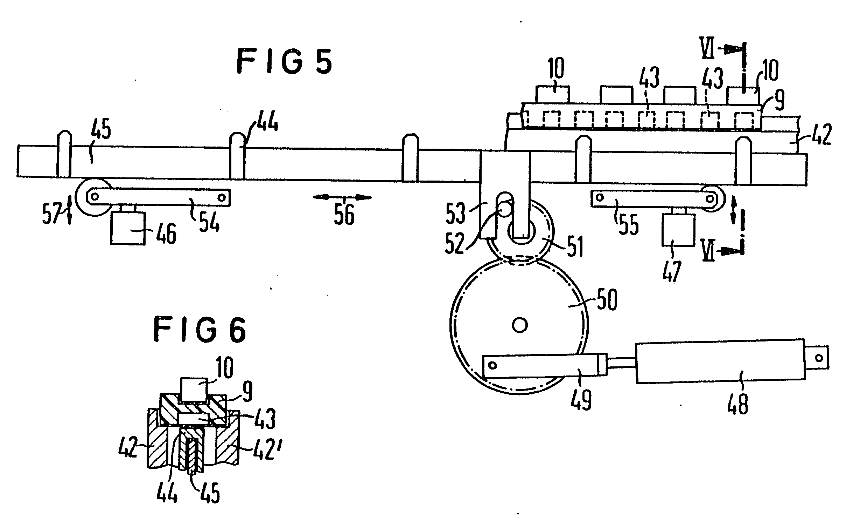

Fig. 5 und Fig. 6 zeigen in vereinfachter Darstellung die Vorschubeinrichtung. Lediglich andeutungsweise gezeichnet ist die Gleitführung mit zwei Führungsschienen 42 und 42', auf denen die einzelnen Magazine 9 geschoben werden. Auf dem Magazin 9 sind die einzelnen Bauteile 10 angeordnet. Die Magazine 9 besitzen jeweils an ihrer Unterseite Ausnehmungen 43, an welchen Mitnehmer 44 einer Vorschubstange 45 eingreifen, um das Magazin in Vorschubrichtung zu bewegen. Die Mitnehmer 44 sind auf der Vorschubstange 45 lösbar befestigt, so daß ihre Abstände an unterschiedliche Magazine angepaßt werden können.

Die Vorschubstange wird durch die Hebezylinder 46 und 47 in vertikaler Richtung, durch den Antriebszylinder 48 in horizontaler Richtung bewegt. Dabei wird die Hubbewegung des Antriebszylinders über die Gabel 49 auf das Zahnrad 50 in eine Drehbewegung umgewandelt, von dort auf das zweite Zahnrad 51 übersetzt und über den exzentrisch angeordneten Kurbelzapfen 52 auf die Antriebsgabel 53 übertragen. Die Transversalbewegung des Antriebszylinders 48 wird also übersetzt und über das Kurbelgetriebe wiederum in eine Transversalbewegung umgewandelt.

Synchronisiert mit dem Antriebszylinder 48 sind die beiden Hebezylinder 46 und 47 so gesteuert, daß sie jeweils gleichzeitig über die Hebel 54 und 55 die Vorschubstange heben und senken. Im Betrieb wird also die Vorschubstange 45 entsprechend dem Doppelpfeil 46 horizontal und entsprechend dem Doppelpfeil 56 vertikal hin und her bewegt.

Im Betrieb werden die beiden Bewegungen überlagert. Die Vorschubstange wird also von einem Ausgangspunkt aus zunächst angehoben, wobei die Mitnehmer 44 mit den Ausnehmungen 43 der jeweiligen Magazine 9 in Eingriff kommen. Dann wird die Vorschubstange durch die Kurbel 52 in Vorschubrichtung bewegt, bis sie durch die Hebezylinder 46 und 47 wieder abgesenkt wird und entgegen der Vorschubrichtung unterhalb der Magazine 9 wieder an ihren Ausgangspunkt zurückkehrt. Durch entsprechende Abstimmung der Antriebskurbel mit dem Übersetzungsgetriebe und dem Antriebszylinder wird erreicht, daß die Vorschubkraft während des Hubes annähernd gleichbleibt, die Endlagen jedoch selbsthemmend wirken.

**Patentansprüche**

1. Fertigungseinrichtung zur Bearbeitung von Kleinbauteilen, insbesondere von elektrischen Bauelementen (10), wobei ein Werkzeugtisch (1) das Bearbeitungswerkzeug (5) trägt und eine Vorschubeinrichtung (42, 44, 45) besitzt, um die Kleinbauteile (10) zur Einzelbearbeitung in einer Reihe im Arbeitstakt des Werkzeuges (5) an diesem vorbeizuführen, mit einem an einer ersten Seite des Werkzeuges (5) angeordneten Eingabeteil (3) sowie einem an der anderen Seite des Werkzeuges angeordneten Ausgabeteil (4), wobei der Eingabeteil (3) und der Ausgabeteil (4) jeweils eine Hebevorrichtung (11) aufweisen, um jeweils eine Transporteinheit (6), welche eine Mehrzahl von parallel ausgerichteten Magazinen (9) und in den Magazinen jeweils eine Mehrzahl von in einer Reihe angeordneten Kleinbauteilen (10) aufzunehmen vermag, in eine bestimmte Höhe zu verstellen, wobei der Eingabeteil (3) ferner eine Ausschiebevorrichtung (12) aufweist, um die Kleinbauteile aus der Transporteinheit (6) auf die Vorschubeinrichtung (29) zu befördern, und wobei der Ausgabeteil (4) ferner eine Einschiebevorrichtung (12a) aufweist, um die Kleinbauteile (10) von der Vorschubeinrichtung (29) in die Transporteinheit (6) einzuschieben, dadurch gekennzeichnet, daß die Magazine (9) als stabförmige und einzeln bewegbare Träger für die in ihnen enthaltene Reihe von Bauelementen (10) ausgebildet sind, daß als Transporteinheit eine mehrere Etagen aufweisende Kassette (6) vorgesehen ist, die in jeder Etage (8) eine Mehrzahl von Magazinen (9) verschiebbar aufnimmt, daß mit der Hebevorrichtung (11) des Eingabeteils (3) jeweils eine bestimmte Etage der dort befindlichen Kassette (6) in die Arbeitshöhe des Werkzeugtisches (1) verstellbar ist und die Ausschiebevorrichtung (12) dazu ausgelegt ist, nacheinander die einzelnen Magazine (9) der betreffenden Etage auf die Vorschubeinrichtung (29) zu schieben, daß mit der Vorschubeinrichtung (29) die bestückten Magazine (9) an dem Werkzeug wobei zum Ausgabeteil beförderbar sind und daß mit der Hebevorrichtung (11) des Ausgabeteils (4) ebenfalls jeweils eine bestimmte Etage (8) in die Arbeitshöhe des Werkzeugtisches (1) verstellbar ist, in welche dann Magazine mittels der Einschiebevorrichtung (12a) einschiebbar sind.

2. Einrichtung nach Anspruch 1, dadurch gekennzeichnet, daß die Hebevorrichtung (11) im Eingabeteil (3) bzw. im Ausgabeteil (4) jeweils über einen Hubzylinder (38) verstellbar ist.

3. Einrichtung nach Anspruch 1 oder 2, dadurch gekennzeichnet, daß die Hebevorrichtung (11) in Höhenschritten, die den Etagenabständen der Kassetten (6) entsprechen, über eine Zahnung (34) einrastbar ist.

4. Einrichtung nach Anspruch 2 oder 3, dadurch gekennzeichnet, daß die Hebevorrichtung (11) über ein vom Hubzylinder (38) betätigbares Klinkenschaltwerk (39, 37) schrittweise verstellbar ist.

5. Einrichtung nach einem der Ansprüche 1 bis 4, dadurch gekennzeichnet, daß die Ausschiebeeinrichtung (12a) einen gabelförmigen, parallel zur Arbeitsfläche des Werkzeugtisches bewegbaren, von der Rückseite in die jeweils eingesetzte Kassette (6) eingreifenden Schieber (13) besitzt.

6. Einrichtung nach Anspruch 5, dadurch gekennzeichnet, daß der Schieber (13) durch einen Druckluftzylinder (16) betätigbar ist.

7. Einrichtung nach einem der Ansprüche 1 bis 6, dadurch gekennzeichnet, daß die Einschiebeeinrichtung (12a) einen in Arbeitshöhe des Werkzeugtisches (1) horizontal bewegbaren Schieber (24) besitzt, der in Richtung der im Ausgabeteil angeordneten Kassette (6) vorstehende Einschiebebolzen (28) aufweist und durch einen Druckluftzylinder (26) betätigbar ist.

8. Einrichtung nach einem der Ansprüche 1 bis 7, dadurch gekennzeichnet, daß die Vorschubeinrichtung (29) Führungsschienen (42, 42') für die einzelnen Magazine aufweist und daß zwischen den Führungsschienen eine Vorschubstange (45) angeordnet ist, welche entsprechend dem Arbeitstakt eine kombinierte Horizontal- und Vertikalbewegung ausführt, derart, daß sie während der Horizontalbewegung in Vorschubrichtung über Mitnehmer (44) mit dem jeweils über ihr angeordneten Magazin (9) in Eingriff ist.

9. Einrichtung nach Anspruch 8, dadurch gekennzeichnet, daß die Vorschubstange (45) über mindestens einen Hebezylinder (46, 47) in Vertikalrichtung und über eine Antriebskurbel (52) in horizontaler Richtung bewegbar ist.

10. Einrichtung nach Anspruch 9, dadurch gekennzeichnet, daß die Horizontalbewegung durch einen über eine Zahnradübersetzung (50, 51) auf die Antriebskurbel (52) wirkenden Antriebszylinder (48) erzeugbar ist.

11. Einrichtung nach einem der Ansprüche 1 bis 10, dadurch gekennzeichnet, daß die einzelnen Etagen (8) der Kassetten (6) mit durchgehenden Zwischenböden (7) voneinander getrennt sind, deren Abstand sich aus der Magazindicke, der Bauteildicke und einem kleinen Spiel ergibt.

12. Einrichtung nach einem der Ansprüche 1 bis 11, dadurch gekennzeichnet, daß die Kassetten an ihrer Vorderseite jeweils mit einem seitlich geführten Deckel (19) verschließbar sind.

13. Einrichtung nach Anspruch 12, dadurch gekennzeichnet, daß am Eingabeteil (3) bzw. am Ausgabeteil (4) jeweils ein Anschlag (23) für den Deckel vorgesehen ist, durch welchen der Deckel während des Hebens und Senkens der Kassette immer in gleicher Höhe gegenüber dem Werkzeugtisch gehalten wird.

14. Einrichtung nach einem der Ansprüche 1 bis 13, dadurch gekennzeichnet, daß an der Kassettenrückseite jeweils Öffnungen (18) für die Gabelenden (17) des Schiebers (13) vorgesehen sind.

15. Einrichtung nach einem der Ansprüche 1 bis 14, dadurch gekennzeichnet, daß die Kassetten (6) jeweils an ihrer Oberseite eine asymmetrisch angeordnete Griffmulde (21) aufweisen.

16. Einrichtung nach einem der Ansprüche 1 bis 5, dadurch gekennzeichnet, daß die Kassetten (6) an ihrer Unterseite mit Gleitschienen (22) versehen sind.

## Claims

1. A processing device for machining small parts, in particular electrical components (10), wherein a tool bench (1) supports the machining tool (5) and has a feeding device (42, 44, 45) to transport the small parts (10) in a row past the tool (5) at the operating rate of the tool (5) for individual processing, comprising an input component (3) which is arranged on a first side of the tool (5) and an output component (4) which is arranged on the other side of the tool, where the imput component (3) and the output component (4) respectively have a lifting device (11) in order respectively to position a transporting device (6) which is capable of accommodating a plurality of parallel magazines (9) and a plurality of small parts (10) which are arranged in a row in respective magazines, at a specific height, wherein the output component (3) further possesses an ejector device (12) to transport the small components from the transporting device (6) onto the feeding device (29), wherein the output component (4) further possesses an insertion device (12a) to insert the small parts (10) from the feeding device (29) into the transporting device (6), characterised in that the magazines (9) are designed as rod-shaped and individually movable carriers for the row of components (10) held therein, and that a cassette (6) which has a plurality of levels is arranged as a transporting unit which removably receives a plurality of magazines (9) on each level (8), that by means of the lifting device (11) of the input component (3) a respective specific level of the cassette (6) therein is adjustable to the operating level of the tool bench (1) and the ejector device (12) is designed to consecutively shift the individual magazines (9) of the respective level onto the feeding device (29), that the filled magazines (9) can be transported past the tool to the output component by means of the feeding device (29) and that by means of the lifting device (11) of the output component (4) a specific level (8) is likewise respectively adjustable to the operating level of the tool bench (1), into which magazines can then be inserted by means of the insertion device (12a).

2. A device as claimed in claim 1, characterised in that the lifting device (11) in the input component (3) and the output component (4) are respectively adjustable by means of a lifting cylinder (38).

3. A device as claimed in claim 1 or 2, characterised in that the lifting device (11) can be engaged in vertical steps, which correspond to the level spacings of the cassettes (6), by means of a toothed mechanism (34).

4. A device as claimed in claim 2 or 3, characterised in that the lifting device (11) is adjustable stepwise by means of a ratchet mechanism (39, 37) which can be operated by the lifting cylinder (38).

5. A device as claimed in one of claims 1 to 4, characterised in that the ejector device (12) has a forked slide (13) which is movable parallel to the operating surface of the tool bench and which engages the respectively inserted cassette (6) from the rear.

6. A device as claimed in claim 5, characterised in that the slide (13) can be operated by a compressed-air cylinder (16).

7. A device claimed in one of claims 1 to 6, characterised in that the insertion device (12a) has a slide (24) which is horizontally movable at the operating level of the tool bench (1) and which has inserting pins (28) which protrude in the direction of the cassette (6) arranged in the output component and can be operated by means of a compressed-air cylinder (26).

8. A device as claimed in one of claims 1 to 7, characterised in that the feeding device (29) has guide rails (42, 42') for the individual magazines and that between the guide rails is arranged a feeding rod (45) which in accordance with the operating rate carries out a combined horizontal and vertical movement in such a manner that during the horizontal movement in the feeding direction it is engaged with the magazine (9), which is respectively arranged above the rod, by means of carriers (44).

9. A device as claimed in claim 8, characterised in that the feeding rod (45) is movable in the vertical direction by means of at least one lifting cylinder (46, 47) and in the horizontal direction by means of the driving crank (52).

10. A device as claimed in claim 9, characterised in that the horizontal movement can be produced by a driving cylinder (48) which acts on the driving crank (52) by means of a transmission gear (50, 51).

11. A device as claimed in one of claims 1 to 10, characterised in that the individual levels (8) of the cassettes (6) are separated from one another by means of continuous intermediate floors (7), the spacing of which levels is given by the thickness of the magazine, the thickness of the component and a small clearence.

12. A device as claimed in one of claims 1 to 11, characterised in that the cassettes can be respectively closed at their front by means of a laterally guided cover (19).

13. A device as claimed in claim 12, characterised in that on the input component (3) and output component (4) is respectively arranged a stop (23) for the cover, by means of which the cover is always maintained at the same level relative to the tool bench during the lifting and lowering operation of the cassette.

14. A device as claimed in one of claims 1 to 13, characterised in that respective openings (18) for the fork ends (17) of the slide (13) are arranged on the rear of the cassette.

15. A device as claimed in one of claims 1 to 14, characterised in that the cassette (6) respectively have an asymmetrical handle hollow (21) on their upper side.

16. A device as claimed in one of claims 1 to 15, characterised in that the cassettes (6) are provided with sliding rails (22) on their underside.


**Revendications**

1. Dispositif de fabrication pour l'usinage de petits composants, notamment de composants électriques (10), dans lequel une table porte-outil (1) porte l'outil d'usinage (5) et comporte un dispositif d'avance (42, 44, 45) permettant de déplacer les petits composants (10) successivement devant cet outil, en vue de leur usinage, à la cadence de travail de l'outil (5), et dans lequel il est prévu une partie d'introduction (3) disposée d'un premier côté de l'outil (5) ainsi qu'une partie de sortie (4) située de l'autre côté de l'outil, et dans lequel la partie d'introduction (3) et la partie de sortie (4) comportent chacune un dispositif de levage (11) permettant d'amener à une hauteur déterminée une unité de transport respective (6), qui peut recevoir une multiplicité de magasins (9) parallèles entre eux et, dans les magasins, respectivement une multiplicité de petits composants (10) disposés selon une rangée, et dans lequel la partie d'introduction (3) comporte en outre un dispositif d'éjection (12) servant à entraîner les petits composants hors de l'unité de transport (6) sur le dispositif d'avance (29), et dans lequel la partie de sortie (4) comporte en outre un dispositif d'insertion (12a) servant à introduire les petits composants (10) depuis le dispositif d'avance (29) dans l'unité de transport (6), caractérisé par le fait que les magasins (9) sont réalisés sous la forme de supports en forme de barreaux, déplaçables individuellement, pour la rangée, qu'il contiennent, de composants (10), qu'il est prévu, en tant qu'unité de transport, une cassette (6) comportant plusieurs étages et qui reçoit, dans chaque étage (8), une multiplicité de magasins (9) aptes à être déplacés, qu'avec le dispositif de levage (11) de la partie d'introduction (3), on peut amener un étage déterminé de la cassette (6), qui s'y trouve située, à la hauteur de travail de la table porte-outil (1) et le dispositif d'éjection (12) est agencé à cet effet de manière à repousser successivement les différents magasins (9) de l'étage considéré sur le dispositif d'avance (29), que les magasins équipés (9) peuvent être entraînés devant l'outil jusqu'à la partie de sortie, au moyen du dispositif d'avance (29), et qu'à l'aide du dispositif de levage (11) de la partie de sortie (4), un étage déterminé (8) peut être également amené respectivement à la hauteur de travail de la table porte-outil (1), dans laquelle des magasins peuvent être alors insérés au moyen du dispositif d'insertion (12a).

2. Dispositif suivant la revendication 1, caractérisé par le fait que le dispositif de levage (11) peut être déplacé dans la partie d'introduction (3) ou dans la partie de sortie (4) respectivement par l'intermédiaire d'un vérin de levage (38).

3. Dispositif suivant la revendication 1 ou 2, caractérisé par le fait que le dispositif de levage (11) peut être verrouillé par encliquetage par l'intermédiaire d'une denture (34) selon des pas en hauteur, qui correspondent aux distances des étages de la cassette (6).

4. Dispositif suivant la revendication 2 ou 3, caractérisé par le fait que le dispositif de levage (11) peut être déplacé pas-à-pas par l'intermédiaire d'un mécanisme d'avance à cliquet (39, 37) pouvant être actionné par l'intermédiaire du vérin de levage (38).

5. Dispositif suivant l'une des revendications 1 à 4, caractérisé par le fait que le dispositif d'éjection (12a) possède un poussoir en forme de fourche (13) déplaçable parallèlement à la surface de travail de la table porte-outil et pouvant s'engager, à partir de la face arrière, dans la cassette (6) respectivement insérée.

6. Dispositif suivant la revendication 5, caractérisé par le fait que le poussoir (13) peut être actionné par l'intermédiaire d'un vérin pneumatique (16).

7. Dispositif suivant l'une des revendications 1 à 6, caractérisé par le fait que le dispositif d'insertion (12a) possède un poussoir (24) déplaçable horizontalement à la hauteur de travail de la table porte-outil (1) et qui possède des tiges d'insertion (28), qui font saillie en direction de la cassette (6) disposée dans la partie de sortie, et peut être actionné au moyen d'un vérin pneumatique (26).

8. Dispositif suivant l'une des revendications 1 à 7, caractérisé par le fait que le dispositif d'avance (29) comporte des rails de guidage (42, 42') pour les différents magasins et qu'entre les rails de guidage se trouve disposée une barre d'avance (45) qui exécute un déplacement horizontal et vertical combiné, conformément à la cadence de travail, et ce de telle sorte que pendant le déplacement horizontal dans la direction d'avance, il est en prise, par l'intermédiaire d'organes d'entraînement (44), avec le magasin (9) qui était disposé respectivement au-dessus de lui.

9. Dispositif suivant la revendication 8, caractérisé par le fait que la barre d'avance (45) est déplaçable par l'intermédiaire d'au moins un vérin de levage (46, 47) suivant la direction verticale et par l'intermédiaire d'une came d'entraînement (52) suivant la direction horizontale.

10. Dispositif suivant la revendication 9, caractérisé par le fait que le déplacement horizontal peut être obtenu par l'intermédiaire d'un vérin d'entraînement (48) agissant sur la came d'entraînement (52) par l'intermédiaire d'une transmission à pignons (50, 51).

11. Dispositif suivant l'une des revendications 1 à 10, caractérisé par le fait que les différents étages (8) des cassettes (6) sont séparés les uns des autres par des planchers intercalaires continus (7), dont la distance réciproque est déterminée par l'épaisseur des magasins, l'épaisseur des composants et un faible jeu.

12. Dispositif suivant l'une des revendications 1 à 11, caractérisé par le fait que les cassettes peuvent être fermées, sur leur face avant, respectivement par un couvercle (19) guidé latéralement.

13. Dispositif suivant la revendication 12, caractérisé par le fait qu'il est prévu pour le couvercle, dans la partie d'introduction (3) et dans la partie de sortie (4), une butée respective (23) au moyen de laquelle le couvercle est maintenu en permanence à une même hauteur par rapport à la table porte-outil pendant le levage et l'abaissement de la cassette.

14. Dispositif suivant l'une des revendications 1 à 13, caractérisé par le fait que sur la face arrière des cassettes il est prévu des ouvertures respectives (18) pour les extrémités (17) de la fourche du poussoir (13).

15. Dispositif suivant l'une des revendications 1 à 14, caractérisé par le fait que les cassettes (6) comportent, respectivement sur leur face supérieure, un organe de préhension en forme d'auge, disposé de façon dissymétrique.

16. Dispositif suivant l'une des revendications 1 à 15, caractérisé par le fait que les cassettes (6) comportent des glissières (22) au niveau de leur face inférieure.

# F I G 1

# FIG 2

FIG 3

# F I G 4

FIG 5

FIG 6